# EUROPÄISCHE PATENTSCHRIFT

(11) **EP 3 824 302 B1**
(45) Veröffentlichungstag und Bekanntmachung des Hinweises auf die Patenterteilung: **20.11.2024**
(21) Anmeldenummer: 19734684.4
(22) Anmeldetag: 29.05.2019
(51) Int. Cl.: G01R 31/34, G01H 1/00, G01M 15/12

(54) **VERFAHREN ZUM BEWERTEN EINES SCHWINGUNGSVERHALTENS EINES ELEKTROMOTORS**
METHOD FOR EVALUATING THE VIBRATION BEHAVIOR OF AN ELECTRIC MOTOR
PROCÉDÉ POUR ÉVALUER UN COMPORTEMENT VIBRATOIRE D'UN MOTEUR ÉLECTRIQUE

(30) Priorität: 17.07.2018 DE 102018211846
(43) Veröffentlichungstag der Anmeldung: 26.05.2021
(73) Patentinhaber: ZIEHL-ABEGG SE, 74653 Künzelsau (DE)
(72) Erfinder: SCHMEZER, Joachim, 74676 Niedernhall (DE)
(74) Vertreter: Ullrich & Naumann PartG mbB
(86) Internationale Anmeldenummer: PCT/DE2019/200051
(87) Internationale Veröffentlichungsnummer: WO 2020/015794

(56) Entgegenhaltungen:
- EP-A1- 2 399 104
- DE-A1- 10 049 506
- DE-A1- 102007 039 699
- DE-A1- 102007 039 699
- DE-A1- 102011 077 490
- DE-A1- 102011 077 490
- DE-A1- 102013 102 648
- DE-A1- 102013 102 648
- DE-A1- 19 702 234
- DE-A1- 19 702 234
- US-A1- 2012 330 578
- US-A1- 2013 197 740
- US-A1- 2013 197 740

## Beschreibung

Die Erfindung betrifft ein Verfahren zum Bewerten eines Schwingungsverhaltens eines Elektromotors.

Elektromotoren sind während ihres Betriebs unterschiedlichsten Arten von Schwingungen und Vibrationen ausgesetzt. Diese Schwingungen können durch den Elektromotor selbst, durch die angetriebene Last oder durch die Umgebung, in der der Elektromotor installiert ist, entstehen. Wenn der Elektromotor beispielsweise Bestandteil eines Ventilators ist, so kann eine Unwucht des Laufrads eine Vibration erzeugen. Zudem kann ein nicht-gleichförmiges Antriebsmoment, das beispielsweise durch eine pulsierende Zwischenkreisgleichspannung entstehen kann, die Schwingungen weiter verstärken. Wenn der Ventilator in einer Industrieumgebung eingebaut ist, die zudem Vibrationen ausgesetzt ist, entstehen weitere Schwingungen.

Motoren bzw. Ventilatoren werden üblicherweise vor der Auslieferung an den Kunden bzw. vor Einbau in ein Gehäuse dynamisch ausgewuchtet, indem unsymmetrische Gewichtsverteilungen oder sonstige schwingungserzeugende Umstände reduziert werden. Allerdings kann es bereits beim Einbau in ein Gehäuse, beim Transport zum Kunden, beim Aufbau in einer Kundenapplikation oder beim Endkunden zu Beschädigungen kommen, die die Wuchtgüte beeinträchtigen. Wenn ein Ventilator in Umgebungen mit anhaftender Verschmutzung, wie beispielsweise in der Landwirtschaft oder bei stark korrosiven Umgebungsbedingungen, betrieben wird, wird über die Lebensdauer des Ventilators ebenfalls die Wuchtgüte beeinträchtigt.

Unwuchten führen zu verstärkten Schwingungen, die wiederum die Bestandteile des Elektromotors sehr stark belasten. So werden beispielsweise die Lager durch Schwingungen erheblich stärker beansprucht, als dies bei einem weniger schwingenden System der Fall wäre. Andererseits belasten die Schwingungen Elektroniken, die in den Elektromotor integriert sind. Dies kann zu einem Lösen von Verlötungen, einem Zerstören von Bauelementen oder gar einem Bruch von Leiterplatten führen. Insgesamt kann ein hohes Maß an Schwingungen dazu führen, dass die Lebensdauer des Elektromotors und/oder seiner Komponenten deutlich reduziert wird.

In EP 2 972 431 B1 ist ein Elektromotor mit Funktionsüberwachung der Motorlager offenbart. Hierzu ist ein Schwingungssensor am Statorflansch auf dessen vom Rotor abgewandten Seite befestigt und misst Vibrationen des Elektromotors. Auf diese Weise kann erkannt werden, wenn Probleme mit dem Lager des Elektromotors entstehen. Allerdings lassen sich jedoch nur bedingt Aussagen über das Schwingungsverhalten des Elektromotors treffen.

DE 10 2007 039 699 A1 offenbart ein Verfahren zum Überwachen von Schwingungspegelwerten bei Antriebssystemen, die beispielsweise ein Getriebe umfassen, das von einem Elektromotor angetrieben wird. Von dem Antriebssystem erzeugter Körper- oder Luftschall wird mit einem oder mehreren Beschleunigungssensoren aufgenommen und aufgenommene Signalverläufe einer Fourier-Analyse unterworfen. Durch Auswerten in verschiedenen Frequenzbändern werden verschiedene Schallquellen unterschieden, beispielsweise der Eingriff von Zahnrädern und der durch ein Lager erzeugte Schall. Während eines "Teach-In" (beispielsweise bei einer Erstinbetriebnahme) werden Schwingungspegelwerte erfasst und durch Multiplikation mit einem Faktor ein Grenzwert berechnet. Bei Überschreiten des Grenzwerts durch einen im Normalbetrieb erfassten Schwingungspegelwert wird eine Warnung und/oder Meldung ausgelöst. Bei der Auswertung können auch aktuelle Betriebssituationen berücksichtigt werden, wie beispielsweise die aktuelle Drehzahl oder das aktuelle Drehmoment. In Absatz [0045] wird zudem das Verwenden eines für die momentane Drehzahl zugehörigen Grenzwertes angesprochen.

Gemäß DE 10 2007 039 699 A1 ist problematisch, dass die dort eingesetzten externen Sensoren etwaige Unwuchten eines Elektromotors außer Acht oder zumindest unzureichend berücksichtigen. Es lassen sich keine konkreten Aussagen über das Schwingungsverhalten des Elektromotors treffen.

Unwuchten führen zu verstärkten Schwingungen, die wiederum die Bestandteile des Elektromotors sehr stark belasten. So werden beispielsweise die Lager durch Schwingungen erheblich stärker beansprucht, als dies bei einem weniger schwingenden System der Fall wäre. Andererseits belasten die Schwingungen Elektroniken, die in den Elektromotor integriert sind. Dies kann zu einem Lösen von Verlötungen, einem Zerstören von Bauelementen oder gar einem Bruch von Leiterplatten führen. Insgesamt kann ein hohes Maß an Schwingungen dazu führen, dass die Lebensdauer des Elektromotors und/oder seiner Komponenten deutlich reduziert wird.

DE 197 02 234 A1 zeigt ein Verfahren zur Überwachung und Qualitätsbeurteilung von sich bewegenden und/oder rotierenden Maschinenteilen. Bei der DE 197 02 234 A1 misst ein Schwingungssensor Schwingungen des Maschinenteils und gibt die Messwerte an eine Auswertelogikschaltung aus. Die Messwerte werden in Frequenzbändern mit Grenzwerten verglichen und auf drohenden oder vorhandenen Schaden oder Fehlfunktion ausgewertet. Dabei werden die Grenzwerte geschwindigkeits- bzw. drehzahlabhängig nachgeführt. Die Druckschrift geht jedoch lediglich pauschal auf eine Maschine ein und offenbart keinerlei elektromotorspezifischen Merkmale, wie beispielsweise einen Schwingungssensor des Elektromotors oder ein auf der Motorelektronik angeordneten Schwingungssensor.

WO 2010/094915 A1 offenbart eine drehzahlabhängige Überwachung von Vibrationsamplituden. Ein Bezug zu einem Elektromotor ist dort nicht offenbart.

DE 10 2011 077 490 A1 offenbart eine Testvorrichtung und ein Testverfahren für einen Elektromotor. Ein Elektromotor wird an der Testvorrichtung befestigt und mit einer vorbestimmten Drehzahl oder in einem vorbestimmten Drehzahlbereich betrieben. Beschleunigungssensoren der Testvorrichtung messen die Vibrationen des Elektromotors. Die derart gewonnenen Messwerte werden mit einem Schwellenwert verglichen. Übersteigen die Messwerte den Schwellenwert, wird der Elektromotor als schadhaft bewertet. Eine Drehzahlerfassung oder ein drehzahlabhängiger Schwellenwert ist dort nicht offenbart.

US 2012/330578 A1 und DE 100 49 506 A1 offenbaren für sich die Vorkehrung eines Schwingungssensors an einem Elektromotor. Die Integration in einen Elektromotor oder gar in eine Motorelektronik des Elektromotors ist dort nicht vorgehen.

Der vorliegenden Erfindung liegt die Aufgabe zugrunde, ein Verfahren der eingangs genannten Art derart auszugestalten und weiterzubilden, dass eine zuverlässige Aussage über das Schwingungsverhalten des Elektromotors getroffen werden kann.

Erfindungsgemäß wird die voranstehende Aufgabe durch die Merkmale des Anspruchs 1 gelöst.

In erfindungsgemäßer Weise ist erkannt worden, dass das Schwingungsverhalten eines Elektromotors dann besonders zuverlässig ausgewertet werden kann, wenn in Abhängigkeit einer aktuellen Drehzahl des Elektromotors eine Bewertung des Schwingungsverhaltens durchgeführt wird. Auf diese Weise können nicht nur Resonanzfrequenzen des Elektromotors identifiziert werden, sondern auch eine Grenzbelastung des Elektromotors, beispielsweise infolge von zu hoher Unwucht, erkannt werden. Dazu wird erfindungsgemäß ein Schwingungswert des Elektromotors gemessen, indem eine Beschleunigung und/oder eine Geschwindigkeit von Schwingungen des Elektromotors gemessen werden. Hierzu wird ein Schwingungssensor verwendet, der in dem Elektromotor integriert oder schwingungstechnisch mit dem Elektromotor gekoppelt ist. Dabei misst der Schwingungssensor Schwingungen in mindestens eine Richtung. Wenn Schwingungen in lediglich einer Richtung gemessen werden sollen, genügt ein einfacher Ein-Achsen-Sensor. Bei Messungen in mehreren Richtungen kann dies dadurch erreicht werden, dass der Schwingungssensor ein Mehrachsen-Sensor ist. Andererseits könnte der Schwingungssensor durch mehrere einzelne Sensoren gebildet sein, die Schwingungen in unterschiedlichen Richtungen messen. Diese Messwerte werden dazu genutzt, um einen Schwingungswert des Elektromotors zu bilden. Dabei repräsentiert der Schwingungswert jede der gemessenen mindestens einen Richtung. Dies bedeutet üblicherweise, dass der Schwingungswert durch ein Tupel von Werten gebildet ist, wie dies beispielsweise bei Vektoren gebräuchlich ist. Es kann jedoch auch Anwendungen geben, bei denen die absoluten Werte in der jeweiligen Richtung nicht von Bedeutung sind. In derartigen Fällen kann der Schwingungswert auch durch einen Betrag gebildet zu sein, bei dem beispielsweise die einzelnen Schwingungswerte in den jeweiligen Richtungen im Sinne einer Vektoraddition addiert sind.

In einem weiteren Schritt wird die aktuelle Drehzahl des Elektromotors bestimmt. Hierbei sollte das Bestimmen der Drehzahl und das Bestimmen der Schwingungswerte in einem engen zeitlichen Zusammenhang stehen. Es sollte gewährleistet sein, dass zum Zeitpunkt des Messens der Schwingungen die ermittelte Drehzahl auch tatsächlich aktuell ist. Bei Elektromotoren mit geringer Drehzahlvarianz kann das Bestimmen der Drehzahl dennoch in relativ großem zeitlichem Abstand zu dem Messen der Schwingungen sein. Hier können mehrere Minuten oder gar Stunden zwischen der Bestimmung der Drehzahl und dem Messen der Schwingungen liegen. Meist dürften das Bestimmen der Drehzahl und das Messen der Schwingungen jedoch in kurzem zeitlichen Abstand, vorzugsweise innerhalb von 10 Sekunden, besonders bevorzugte Weise innerhalb von 1 Sekunde, ganz besonders bevorzugte Weise innerhalb von 0,1 Sekunden erfolgen. Zum Bestimmen der aktuellen Drehzahl kann ein dedizierter Drehzahlsensor zum Einsatz kommen. Andererseits kann die Drehzahl aus anderen Größen des Elektromotors abgeleitet werden. So kann ein Drehzahlwert aus der Motorelektronik bezogen oder aus der Frequenz der Speisespannung abgeleitet werden. Entsprechende Verfahren zur Bestimmung der Drehzahl eines Elektromotors sind aus der Praxis hinlänglich bekannt.

Mit der bestimmten aktuellen Drehzahl wird ein Referenzwert bestimmt oder geladen und mit dem bestimmten Schwingungswert verglichen. Dabei kann eine Liste von Referenzwerten mit der jeweils zugehörigen Drehzahl in einem Speicher abgelegt sein und basierend auf der aktuellen Drehzahl ein Referenzwert aus der Liste geladen werden. Es wäre auch denkbar, dass die Referenzwerte als Funktion in Abhängigkeit der Drehzahl in einem Speicher abgelegt sind, wobei die Funktion eine Näherung des tatsächlichen Verhaltens und/oder abschnittsweise definiert sein kann. Das Bestimmen des Referenzwertes würde dann ein Berechnen der Funktion mit der aktuellen Drehzahl als Variable beinhalten. Allerdings kann der Referenzwert auch von einem oder mehreren Prüfsensoren einer Prüfanlage kommen, der die Schwingungen des Elektromotors zeitgleich oder zeitnah zu dem Schwingungssensor des Elektromotors misst. Auf diese Weise kann das erfindungsgemäße Verfahren sowohl in einem Nennbetrieb des Elektromotors als auch in einem Kalibrierbetrieb in einer Prüfanlage eingesetzt werden.

Aus dem Vergleich des bestimmten Schwingungswerts und des (bestimmten) Referenzwertes wird ein Bewertungsmaß bestimmt, das repräsentativ für das Schwingungsverhalten des Elektromotors ist. Basierend auf diesem Bewertungsmaß kann ermittelt werden, ob ein kritisches Schwingungsverhalten des Elektromotors vorliegt oder ob der Elektromotor innerhalb zulässiger Schwingungsgrenzen betrieben wird. Auf diese Weise kann nicht nur das durch die Lager ausgelöste Schwingungsverhalten beurteilt werden, sondern auch die Schwingungen, die durch die Last, beispielsweise ein Laufrad eines Ventilator mit Unwucht, oder durch die Einbauumgebung erzeugt werden. Da es während eines Nennbetriebs eines Elektromotors für eine unzulässig hohe Schwingungsbelastung des Elektromotors letztendlich von untergeordneter Bedeutung ist, wodurch die Schwingungen erzeugt werden, kann durch das erfindungsgemäße Verfahren das Schwingungsverhalten des Elektromotors umfassend bewertet werden.

Bei Einsatz des erfindungsgemäßen Verfahrens während eines Kalibrierbetriebs in einer Prüfanlage kann das Bewertungsmaß angeben, wie sich Schwingungen des Elektromotors auf die Sensorsignale des Schwingungssensors des Elektromotors und des Prüfsensors auswirken. Das Bewertungsmaß kann beispielsweise angeben, ob der Schwingungssensor des Elektromotors korrekt arbeitet und/oder wie sich einzelne Schwingungen in dem Sensorsignal des Schwingungssensors des Elektromotors auswirken und/oder wie Schwingungswerte in Vibrationslevel oder Vibrationszonen eingeordnet und bewertet werden können. Diese Auflistung zeigt, wie flexibel das Bewertungsmaß eingesetzt werden kann. Wesentlich ist, dass durch das Bewertungsmaß Informationen über das Schwingverhalten angebbar sind.

Prinzipiell ist es für das erfindungsgemäße Verfahren unerheblich, bei welchem Elektromotor das Verfahren eingesetzt wird. Wesentlich ist, dass eine aktuelle Drehzahl bestimmbar ist, was jedoch bei sehr vielen Elektromotoren der Fall ist. Wichtig ist auch, dass ein Schwingungssensor in den Elektromotor integriert oder zumindest an diesen unmittelbar angebaut werden kann. Vorzugsweise kommt das erfindungsgemäße Verfahren jedoch in Zusammenhang mit EC-Motoren (Electronically Commutated Motoren) zum Einsatz.

Das Bewertungsmaß kann prinzipiell ebenso auf verschiedenste Weise gebildet sein. Wichtig ist, dass das Bewertungsmaß Informationen über das Schwingungsverhalten des Elektromotors beinhaltet. Da das Schwingungsverhalten in einem Nennbetrieb des Elektromotors vielfach in Bezug auf einen maximal zulässigen Schwingungswert gesetzt werden wird, gibt das Bewertungsmaß vorzugsweise an, wie weit der Schwingungswert von einem maximal zulässigen Schwingungswert abweicht. Wie das Bewertungsmaß konkret aussieht, dürfte von dem jeweiligen Anwendungsfall abhängen. So kann es genügen, wenn eine Aussage getroffen wird, ob der maximal zulässige Schwingungswert erreicht ist oder nicht. In diesem Fall kann das Bewertungsmaß durch eine einfache binäre Aussage gebildet sein. Meist wird es jedoch von Bedeutung sein, wie groß der "Abstand" des gemessene Schwingungswert zu dem maximal zulässigen Schwingungswert ist. In diesen Fällen kann das Bewertungsmaß beispielsweise durch eine Bewertungsskala mit natürlichen Zahlen zwischen 1 und 10 oder einer Dezimalzahl zwischen 0 und 1 oder einer Prozentzahl zwischen 0 und 100 % gebildet sein. Dabei kann sich einer der Randwerte auf die Schwingungen unmittelbar nach einer Auswuchtung beziehen, während der andere Randwert - beispielsweise - das Erreichen des maximal zulässigen Schwingungswertes angibt.

Nach dem Bestimmen des Bewertungsmaßes gibt es verschiedene Möglichkeiten, wie auf die Bewertung des Schwingungsverhaltens reagiert werden kann. Prinzipiell sind alle Reaktionen denkbar, die auf das bewertete Schwingungsverhalten eingehen. In einer Weiterbildung wird jedoch eine Warnmeldung erzeugt, die das Erreichen oder Überschreiten eines maximal zulässigen Schwingungswertes anzeigt. Wie die Warnmeldung ausgegeben wird, hängt wiederum von dem jeweiligen Anwendungsszenarium ab. So wäre es, insbesondere in Industrie 4.0 Umgebungen, denkbar, dass eine entsprechende Warnmeldung über ein Netzwerk versendet wird. Diese Warnmeldung kann beispielsweise von Wartungspersonal oder Bedienpersonal empfangen und geeignete Gegenmaßnahmen ergriffen werden.

Eine Warnmeldung kann auch durch eine einfache Leuchtdiode ausgegeben werden, die beispielsweise in einem Normalbetrieb grün und bei Erreichen oder Überschreiten des maximal zulässigen Schwingungswertes rot leuchtet. Hier wäre es auch denkbar, dass beispielsweise bei Überschreiten eines ersten Schwingungsgrenzwertes die Leuchtdiode orange leuchtet. Eine Warnmeldung kann auch - insbesondere bei Umgebungen mit anhaftendem Schmutz - dazu genutzt werden, dass Reinigungs- und/oder Wartungsarbeiten ausgelöst werden.

Alternativ oder zusätzlich können bei Erreichen oder Überschreiten eines maximal zulässigen Schwingungswertes Maßnahmen zum Schutz des Elektromotors eingeleitet werden. Diese Maßnahmen können beispielsweise beinhalten, dass die Drehzahl des Elektromotors verändert wird. Meist dürfte hier eine Reduzierung der Drehzahl zu einer Reduzierung der Schwingungen beitragen. Auf diese Weise kann der Elektromotor eventuell in einen weniger stark schwingenden Betriebszustand versetzt werden. Eine andere Maßnahme könnte beinhalten, dass die Ansteuerung in einen ruhigeren Betriebsmodus geschaltet wird, in dem beispielsweise Ripple im Antriebsmoment stärker reduziert sind. Hierzu kann eine Bewertungseinheit, die das Bewertungsmaß basierend auf einem Vergleich zwischen dem Schwingungswert und dem Referenzwert bestimmt, mit der Motorelektronik kommunizierend verbunden sein.

Alternativ oder zusätzlich kann das Bewertungsmaß dazu verwendet werden, um Beschädigungen des Elektromotors und/oder der betriebenen Last zu erkennen. So kann beispielsweise das Bewertungsmaß bei zwei aufeinanderfolgenden Aktivierungen des Elektromotors miteinander verglichen werden. Wenn die Bewertungsmaße über einen vorgegebenen Schwellenwert voneinander abweichen, liegt möglicherweise eine Beschädigung vor. Auf diese Weise können beispielsweise auch Transportschäden erkannt werden. Hier wären die beiden aufeinanderfolgenden Aktivierung durch einen Betrieb während der Endprüfung des Elektromotors und eine Erstinbetriebnahme gegeben. Eine zu große Abweichung kann durch Ausgabe einer Warnmeldung und/oder durch Verweigern eines Betriebs des Elektromotors signalisiert werden.

Das Bewertungsmaß wird dazu genutzt, eine Bewertung der Schwingungen der Einbauumgebung vorzunehmen. Wenn die Drehzahl des Elektromotors gleich 0 ist, kann der Elektromotor selbst keine Schwingungen erzeugen. Sämtliche bei dem Schwingungssensor gemessenen Schwingungen müssen daher von der Einbauumgebung (beispielweise Wärmetauscher, Lüftungskanäle, Wärmepumpe, Klimakastengehäuse etc.) kommen. Damit lassen sich die Schwingungen der Einbauumgebung erfassen und bewerten. Diese Bewertung kann in einem Speicher abgelegt und bei einem Betrieb des Elektromotors berücksichtigt werden. Eine derartige Bewertung der Einbauumgebung kann beispielsweise dann erfolgen, wenn eine Versorgungsspannung an dem Elektromotor gelegt wird. Da dann der Beginn einer Drehbewegung des Elektromotors meist ohnehin durch das Starten einer Motorelektronik verzögert ist, kann eine kurze zusätzliche Verzögerung zum Bewerten der Schwingungen der Einbauumgebung in Kauf genommen werden. Des Weiteren ist eine Bewertung während eines Stillstands des Motors (auch ohne vorheriger Abschaltung der Versorgungsspannung) möglich. Hier ist denkbar, dass nach Ablauf einer vorgegebenen Zeitdauer eine Bewertung vorgenommen wird. Wenn die neue Bewertung dann getriggert wird, wenn der Elektromotor noch läuft, so kann die Bewertung zurückgestellt und nach Stillstand des Motors vorgenommen werden. Sollte eine Bewertung der Schwingungen der Einbauumgebung einen sehr hohen oder gar zu hohen Schwingungswert ergeben, so kann eine Warnmeldung ausgegeben werden und/oder ein Betrieb des Elektromotors verweigert werden.

In einer Ausgestaltung des Schwingungssensors wird der Schwingungswert unter Verwendung eines Schwingungssensors bestimmt, der in einer Motorelektronik des Elektromotors angeordnet ist. Viele Elektromotoren, insbesondere EC-Motoren, weisen eine Motorelektronik auf, die zur Steuerung und/oder Regelung des Elektromotors benötigt wird. Derartige Motorelektroniken erzeugen beispielsweise die Speisespannung für Wicklungen des Stators und/oder Rotors. Eine derartige Anordnung eines Schwingungssensors ist beispielsweise in der DE 10 2018 211 838 A1 beschrieben, auf deren Inhalt hiermit ausdrücklich Bezug genommen wird. Dabei kann diese Motorelektronik innerhalb des Elektromotors angeordnet sein, beispielsweise in einem Elektronikgehäuse, das in einer Statorbuchse ausgebildet ist. Es ist aber auch denkbar, dass die Motorelektronik in einem separaten Elektronikgehäuse angeordnet ist und dass dieses Elektronikgehäuse an den Elektromotor geflanscht oder geschraubt ist. Auch in diesem Fall wird ein in der Motorelektronik angeordneter Schwingungssensor als Schwingungssensor des Elektromotors betrachtet.

In einer anderen Ausgestaltung des Schwingungssensors wird der Schwingungswert unter Verwendung eines Schwingungssensors bestimmt, der Bestandteil einer in einem Lagerrohr des Elektromotors angeordneten Sensoranordnung ist. Viele Elektromotoren, insbesondere Elektromotoren im mittleren und größeren Leistungsbereich (also von etwa 100 W bis 15 kW) weisen ein Lagerrohr auf, in dem die Welle des Elektromotors drehbar gelagert ist. Zwischen der Welle und der Wandung des Lagerrohrs besteht ein Zwischenraum, der vielfach zwischen 4 mm und 8 mm breit ist. Dieser Zwischenraum kann für eine Sensoranordnung verwendet werden, die Betriebsparameter des Elektromotors messbar macht. Eine derartige Sensoranordnung ist beispielsweise in der DE 10 2018 211 833 beschrieben, auf deren Inhalt hiermit ausdrücklich Bezug genommen wird.

Der Schwingungssensor selbst kann auf verschiedenste Arten gebildet sein. Wesentlich ist, dass der Schwingungssensor dazu in der Lage ist, Beschleunigungswerte und/oder Geschwindigkeitswerte für die gemessene Schwingung zu liefern. Der Schwingungssensor kann dabei durch ein MEMS (Micro Electro-Mechanical System)-Beschleunigungssensor, ein piezoelektrischer Beschleunigungssensor, ein Mikrofon (beispielsweise ein MEMS-Mikrofon) oder Dehnungsmessstreifen gebildet sein. Entsprechend geeignete Sensoren sind aus der Praxis hinlänglich bekannt.

Je nach Art der Bewertung des Schwingungsverhaltens des Elektromotors kann eine Messung von Schwingungen in einer oder mehr Richtungen angebracht sein. Vorzugsweise werden jedoch Schwingungen in drei Richtungen gemessen, die jeweils in dem Schwingungswert Berücksichtigung finden. Dabei sind die drei Richtungen vorzugsweise jeweils senkrecht zueinander. Diese drei Richtungen können beispielsweise ein klassisches kartesisches Koordinatensystem aufspannen. Dabei kann beispielsweise eine erste Richtung parallel zur Achse des Elektromotors sein, während eine der weiteren Richtungen parallel zu einer Bezugsebene des Elektromotors angeordnet ist.

Zum Erhalten eines möglichst umfassenden Bildes über das Schwingungsverhalten des Elektromotors werden - insbesondere in einem Nennbetrieb des Elektromotors - das Bestimmen des Schwingungswerts und die Bewertung des Schwingungsverhaltens wiederholt durchgeführt. Dabei können das Bestimmen des Schwingungswerts und die Bewertung des Schwingungsverhaltens durch besondere Ereignisse getriggert werden. Ein derartiges Ereignis kann beispielsweise das Anschalten und Hochfahren des Elektromotors oder eine Änderung der Drehzahl sein. Besonders bevorzugter Weise wird das Bestimmen des Schwingungswerts und die Bewertung des Schwingungsverhaltens periodisch durchgeführt. Dies bedeutet, dass in vordefinierten zeitlichen Abständen das Durchführen der Schritte ausgelöst wird. Dabei kann die Periodenlänge, also die zeitlichen Abstände, von dem jeweiligen Anwendungsszenarium abhängen. Wenn beispielsweise auf Verschmutzungen auf einem Laufrad eines Ventilators reagiert werden soll, so dürfte es genügen, wenn täglich, wöchentlich oder gar monatlich das Schwingungsverhalten bewertet wird. Bei Betriebsumgebungen, in denen regelmäßige Schwingungsänderungen und regelmäßige Drehzahländerung üblich sind, dürften sich kürzere Periodenlängen anbieten. Hier wäre beispielsweise eine stündliche Bewertung oder eine Bewertung im Abstand weniger Minuten denkbar.

Vorzugsweise wird ein ermittelter Schwingungswert und/oder ein bestimmtes Bewertungsmaß in einem Speicher abgespeichert. Auf diese Weise kann der Schwingungswert und/oder das Bewertungsmaß während des Betriebs mitgeloggt werden. Dabei kann der Speicher über eine Energieversorgung, beispielsweise eine Batterie, gepuffert sein. Vorzugsweise wird jedoch ein nicht-flüchtiger Speicher, wie beispielsweise ein Flash-Speicher, ein EEPROM (Electronically Erasable Programmable Read-Only Memory), ein NVRAM (Non-Volatile Random Access Memory) oder eine anderer Halbleiterspeicher, verwendet. Beim Abspeichern des Schwingungswerts und/oder des Bewertungsmaßes bietet es sich an, die aktuelle Drehzahl, bei der der Schwingungswert erfasst worden ist, mit abzuspeichern. Zusätzlich bietet es sich an, einen Zeitstempel abzuspeichern, der den Zeitpunkt des Erfassens des Schwingungswerts angibt. Vorzugsweise steht hierzu eine Echtzeituhr zur Verfügung, die Daten für einen entsprechenden Zeitstempel liefern kann.

Zusätzlich oder alternativ kann ein ermittelter Schwingungswert und/oder ein bestimmtes Bewertungsmaß über eine Kommunikationsschnittstelle übertragen werden. Die Kommunikationsschnittstelle kann dabei auf verschiedenste Arten aufgebaut sein. Drahtlose Übertragungsverfahren, beispielsweise funkbasierte oder optische Verfahren, lassen sich ebenso einsetzen wie kabelgebundene Verfahren. Die Übertragung kann analog oder digital, seriell oder parallel, paketiert oder in Datenströmen, über einen Bus oder Direktverbindungen erfolgen. Die jeweils eingesetzte Übertragungstechnik wird von dem jeweiligen Einsatzszenarium abhängen. Beispielhaft, jedoch nicht auf diese beschränkt, sei auf Bluetooth, Bluetooth LE (Low Energy), NFC (Near Field Communication), Ethernet, RS485, Modbus, Profibus, CAN-Bus oder USB (Universal Serial Bus) verwiesen. Vorzugsweise bietet die Kommunikationsschnittstelle dabei - direkt oder indirekt - einen Zugang zu einem Weitbereichsnetzwerk.

Die Kommunikationsschnittstelle kann kommunizierend mit einer Motorelektronik verbunden sein. Dabei kann die Motorelektronik dazu ausgebildet sein, basierend auf über die Kommunikationsschnittstelle empfangenen Schwingungswerten und/ oder Bewertungsmaßen eine Anpassung einer Ansteuerung der Wicklungen des Stators und/oder des Rotors vorzunehmen. So kann beispielsweise ein Bewertungsmaß anzeigen, dass eine hohe Schwingungsbeanspruchung des Elektromotors vorliegt. In diesem Fall kann die Motorelektronik den Elektromotor derart ansteuern, dass die Schwingungsbeanspruchung reduziert wird. Dies könnte dadurch geschehen, dass die Drehzahl des Elektromotors geringfügig verändert wird, um den Elektromotor beispielsweise aus einer Resonanzfrequenz zu bewegen.

Zum Ermitteln eines Referenzwerts, der in einem Nennbetrieb des Elektromotors genutzt werden kann, werden vorzugsweise Kalibrierungs- und/oder Hochlaufmessungen durchgeführt. Dabei wird der Elektromotor bei mehreren unterschiedlichen Drehzahlen betrieben und Schwingungen des Elektromotors gemessen. Bei Hochlaufmessungen wird die Drehzahl kontinuierlich oder quasikontinuierlich erhöht, wodurch sich beispielsweise Resonanzfrequenzen besonders gut auffinden lassen. Bei den Kalibrierungs- und/oder Hochlaufmessungen werden die Schwingungen einerseits mit dem Schwingungssensor des Elektromotors und andererseits mit mindestens einem Prüfsensor gemessen. Dabei ist der mindestens eine Prüfsensor vorzugsweise Bestandteil einer Prüfanlage. Der mindestens eine Prüfsensor ist dabei derart mit dem Gehäuse des Elektromotors gekoppelt, dass Schwingungen des Elektromotors definiert und möglichst optimal zu dem Prüfsensor gelangen können. Durch das gleichzeitige Erfassen mit dem Schwingungssensor des Elektromotors kann eine direkte Beziehung zwischen dem Schwingungssensor und dem Prüfsensor hergestellt und mit dem erfindungsgemäßen Verfahren bewertet werden. Insbesondere wenn der Schwingungssensor in einer Vergussmasse eingebettet ist, werden die Schwingungen des Elektromotors gedämpft zu dem Schwingungssensor des Elektromotors gelangen. Durch das gleichzeitige Messen mit dem mindestens einen Prüfsensor kann eine Beziehung zwischen den Messwerten des Schwingungssensors und den Messwerten des mindestens einen Prüfsensors hergestellt werden. Diese Beziehung kann sich dann in dem jeweils relevanten Referenzwert widerspiegeln. Denn je nach Dämpfverhalten zwischen dem Schwingungssensor und dem "Rest" des Elektromotors wird der Referenzwert unterschiedlich stark abweichen.

Vorzugsweise wird zusätzlich zu dem Bestimmen der Referenzwerte zu unterschiedlichen Drehzahlen ein Abweichungswert bestimmt, der einen Zusammenhang zwischen einem Messwert des Schwingungssensors des Elektromotors und einem Messwert des mindestens einem Prüfsensors angibt. Dieser Abweichungswert kann in einer Weiterbildung zu einem Anpassen des maximal zulässigen Schwingungswerts genutzt werden. Auf diese Weise kann auf die Übertragungscharakteristik von Schwingungen zu dem Schwingungssensor des Elektromotors eingegangen werden.

In einer Weiterbildung kann eine Referenzkennlinie, die mehrere Referenzwerte bei unterschiedlichen Drehzahlen des Elektromotors enthält, in einer Motordatenbank abgespeichert werden. Diese Motordatenbank könnte Betriebsparameter mehrere Elektromotoren enthalten, wobei jeder Datensatz in der Datenbank das Betriebsverhalten des jeweils zugehörigen dezidierten Elektromotors nachbildet ("digitaler Zwilling"). Ein derartiges Datenbanksystem ist beispielsweise in der DE 10 2018 201 707 A1 beschrieben.

Ein Elektromotor, der das erfindungsgemäße Verfahren nutzt, umfasst - neben einem Stator und einem Rotor - einen Schwingungssensor, eine Drehzahlermittlungseinheit, einen Komparator und eine Bewertungseinheit. Der Schwingungssensor ist zum Messen von Schwingungen des Elektromotors in mindestens einer Richtung ausgebildet. Die Drehzahlermittlungseinheit ist zum Bestimmen der aktuellen Drehzahl des Elektromotors ausgebildet. Der Komparator vergleicht die unter Verwendung des Schwingungssensors bestimmten Schwingungswerte mit einem Referenzwert und gibt das Vergleichsergebnis an die Bewertungseinheit aus, die zum Bestimmen eines Bewertungsmaßes zur Bewertung des Schwingungsverhaltens basierend auf dem Vergleichsergebnis ausgebildet ist. Dabei sei darauf hingewiesen, dass diese Komponenten nicht zwingend ausschließlich für die Bewertung des Schwingungsverhaltens zur Verfügung gestellt sein müssen. Vielmehr können auch Komponenten genutzt werden, die für andere Zwecke ohnehin vorhanden sind. So kann beispielsweise die Drehzahlermittlungseinheit für die Motorsteuerung bereitgestellt sein, um eine passende Ansteuerung für die Wicklungen des Rotors und/oder des Stators erzeugen zu können. Ferner kann beispielsweise die Bewertungseinheit oder der Komparator in einem Mikrocontroller der Motorsteuerung implementiert sein.

Vorzugsweise umfasst der Elektromotor eine Schnittstelle, die zum Austauschen von Schwingungswerten und/oder Kalibrierungsschwingungswerten mit einer Prüfanlage ausgebildet ist. Auf diese Weise kann eine Vermessung des Elektromotors in einer Kalibrierung- und/oder Hochlaufmessung begünstigt werden. Die Schnittstelle kann wiederum auf unterschiedliche Weisen gebildet sein. Drahtlose Schnittstellen lassen sich ebenso einsetzen wie kabelgebundene. Da der Elektromotor in der Prüfanlage ohnehin kabelgebunden betrieben wird, bietet sich jedoch eine kabelgebundene Schnittstelle an.

Es gibt nun verschiedene Möglichkeiten, die Lehre der vorliegenden Erfindung in vorteilhafter Weise auszugestalten und weiterzubilden. Dazu ist einerseits auf die den nebengeordneten Ansprüchen nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: ein Blockdiagramm mit einem Elektromotor und einer Prüfanlage sowie der Interaktion zwischen diesen Bestandteilen,
- Fig. 2: ein Ablaufdiagramm eines erfindungsgemäßen Verfahrens zum Bewerten des Schwingungsverhaltens eines Elektromotors während eines Kalibrierungsbetriebs und
- Fig. 3: ein Ablaufdiagramm eines erfindungsgemäßen Verfahrens zum Bewerten des Schwingungsverhaltens eines Elektromotors während eines Nennbetriebs.

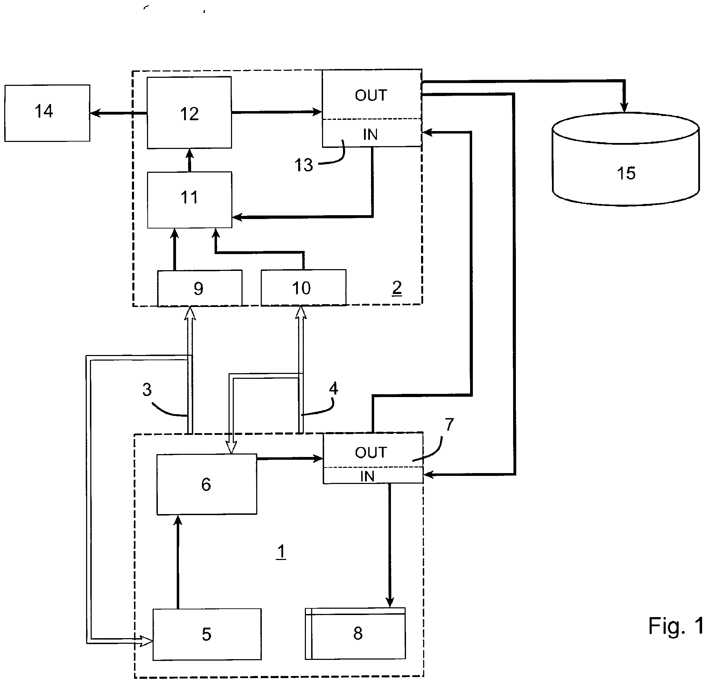

Fig. 1 zeigt ein Blockdiagramm mit einem System aus einem Elektromotor 1 und einer Prüfanlage 2, wobei in Fig. 1 jeweils die für das Verfahren relevantesten Komponenten eingezeichnet sind. Der Elektromotor 1 ist Bestandteil eines Ventilators und erzeugt beim Betrieb Schwingungen, was durch Pfeil 3 dargestellt ist, und eine Drehzahl, was durch den Pfeil 4 dargestellt ist. Die Schwingungen 3 werden durch einen (internen) Schwingungssensor 5 des Elektromotors in mindestens einer Richtung gemessen. Die durch den Schwingungssensor 5 ermittelten Messwerte werden an einen Prozessor 6 übergeben, der beispielsweise durch einen Mikrocontroller gebildet ist. Dieser Prozessor 6 kann beispielsweise eine Analog-Digital-Wandlung vornehmen und/oder das Erfassen der Messwerte steuern. Damit kann der Prozessor 6 aus den Messwerten Schwingungswerte ermitteln. Zudem wird durch den Prozessor 6 ein Programm ausgeführt, das als Bewertungseinheit fungiert und ein Bewertungsmaß berechnet. Darüber hinaus ist der Prozessor 6 zum Bestimmen der aktuellen Drehzahl ausgebildet.

Der Prozessor 6 ist mit einer Schnittstelle 7 und einem (internen) Speicher 8 verbunden. Die Schnittstelle 7 stellt eine Kommunikationsverbindung zu der Prüfanlage 2 dar. Über einen Ausgang OUT der Schnittstelle 7 können Informationen an die Prüfanlage 2 gesandt werden, über einen Eingang IN der Schnittstelle 7 können Informationen von der Prüfanlage 2 empfangen werden, wobei der Eingangskanal und der Ausgangskanal nicht zwingend getrennt voneinander implementiert sein müssen, sondern auch eine gemeinsame Kommunikationsleitung nutzen können, beispielsweise unter Verwendung eines Busses. Der Speicher 8 dient zum Speichern von Referenzwerten und/oder bestimmten Schwingungswerten und/oder bestimmten Bewertungsmaßen.

Die Prüfanlage 2 umfasst mindestens einen Prüfsensor 9, einen Drehzahlsensor 10, eine Datenerfassungseinheit 11, einen Prozessor 12 und eine Schnittstelle 13. Der mindestens eine Prüfsensor 9 ist dazu ausgebildet, die Schwingungen 3 des Elektromotors 1 zu messen. Dazu ist der mindestens eine Prüfsensor 9 mit dem Elektromotor schwingungstechnisch gekoppelt. Der Drehzahlsensor 10 misst die aktuelle Drehzahl 4 des Elektromotors 1. Sowohl der/die Prüfsensor/en 9 als auch der Drehzahlsensor 10 übergeben gemessene Messwerte an die Datenerfassungseinheit 11, die wiederum Informationen an den Prozessor 12 weitergeben kann. Der Prozessor 12 ist mit einer Datenausgabeeinheit 14 verbunden, über die beispielsweise eine Wuchtanzeige erfolgen kann oder Ergebnisse einer Endprüfung ausgegeben werden können. Der Prozessor ist zudem mit der Schnittstelle 13 verbunden, die wie Schnittstelle 7 einen Eingang IN und einen Ausgang OUT umfasst. Der Eingang IN der Schnittstelle 13 ist mit dem Ausgang OUT der Schnittstelle 7 kommunizierend verbunden, während der Ausgang OUT der Schnittstelle 13 mit dem Eingang IN der Schnittstelle 7 kommunizierend verbunden ist. Ergänzend ist der Eingang IN der Schnittstelle 13 mit der Datenerfassungseinheit 11 verbunden und der Ausgang OUT der Schnittstelle 13 mit einer Datenbank 15, die eine Motordatenbank zur Speicherung von Betriebsparametern des Elektromotors 1 darstellt.

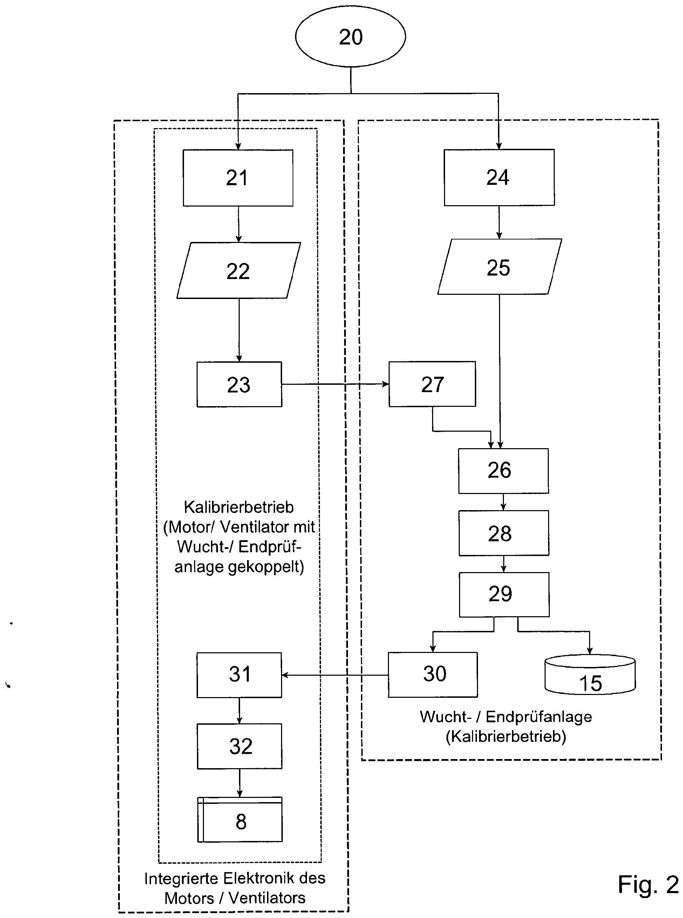

Ein beispielhaftes Verhalten des in Fig. 1 dargestellten Systems ist in Fig. 2 als Flussdiagramm dargestellt. In einem initialen Schritt 20 wird der Elektromotor mit einer Drehzahl n betrieben. Dabei erzeugt der Elektromotor 1 Schwingungen, die durch einen Schwingungswert S - eine vorzugsweise mehrdimensionale Größe - repräsentiert sind. Nach Schritt 20 verzweigt sich das Flussdiagramm in einen Teil, der auf der Prüfanlage abläuft und einen Teil, der auf dem Elektromotor bzw. auf dessen Motorelektronik abläuft.

In Schritt 21 werden in der integrierten Elektronik des Elektromotors / Ventilators Schwingungswerte des Motors mit dem Schwingungssensor 5 des Elektromotors 1 erfasst. Gleichzeitig wird die aktuelle Drehzahl des Elektromotors bestimmt, was durch Auslesen eines entsprechenden Speicherwerts der Motorelektronik erfolgen kann. In Schritt 22 wird mit dem Schwingungswert S und der zugehörenden Drehzahl ein Wertepaar W_{Motor} erzeugt, das dann in Schritt 23 über die Schnittstelle 7 an die Prüfanlage 2 übergeben wird. Gleichzeitig werden in Schritt 24 die Schwingungen 3 des Elektromotors 1 mittels des mindestens einen Prüfsensors 9 gemessen. Die auf diese Weise gewonnenen Schwingungswerte werden dann in Schritt 25 zusammen mit der aktuellen Drehzahl in einem Wertepaar W_{Prüfanlage} zusammengefasst. Dieses Wertepaar W_{Prüfanlage} wird in Schritt 26 zusammen mit dem im Wesentlichen gleichzeitig erfassten Wertepaar W_{Motor} an den Prozessor 12 übergeben. Das Wertepaar W_{Motor} ist in Schritt 27 über die Verbindung zwischen der Schnittstelle 7 und 13 aus Schritt 23 an die Prüfanlage übergeben worden. In Schritt 28 werden die Wertepaare W_{Motor} und W_{Prüfanlage} miteinander verglichen, so dass die Messwerte des Prüfsensors 9 einen Referenzwert im Sinne des erfindungsgemäßen Verfahrens darstellen. In Schritt 29 wird eine Kalibrierung der Schwingungswerte bei gleicher Drehzahl vorgenommen. Dies kann das Bestimmen eines Abweichungswertes und/oder eines Bewertungsmaßes umfassen. Die Schwingungswerte bei jeweils gleicher Drehzahl W_{Motor} und W_{Prüfanlage} können dann als Referenzwerte in der Datenbank 15 abgelegt und in Schritt 30 über die Schnittstelle 13 an den Elektromotor 1 übergeben werden. Bei dem Elektromotor werden in Schritt 31 die Referenzwerte und/oder die Abweichungswerte aus der Schnittstelle 7 übergeben und in Schritt 32 in dem internen Speicher 8 abgespeichert.

Durch wiederholtes Durchführen dieser Abläufe bei unterschiedlichen Drehzahlen können Referenzkennlinien des Elektromotors sowie der Prüfanlage aufgenommen und eine Schar von Referenzwerten mit dazugehörenden Drehzahlen in dem internen Speicher 8 des Elektromotors und der Datenbank 15 abgelegt werden. Auf diese Weise kann eine Lookup-Tabelle entstehen, die bei der späteren Verwendung des Verfahrens im "normalen" Betrieb des Elektromotors verwendet werden kann.

Die durch den Prüfsensor 9 erfassten Schwingungswerte des Motors bzw. Ventilators können zur Bewertung und Einordnung in Vibrationslevel oder Vibrationszonen herangezogen werden. Durch den Abgleich der Messwerte des internen Sensors 5 und des Prüfsensors 9 kann im weiteren Einsatz des Motors ohne Kopplung mit einer Prüfanlage auf die tatsächlich vorliegenden Schwingungen geschlossen und in einer Kundenapplikation eine Bewertung des vorliegenden Vibrationslevels vorgenommen werden.

Zusätzlich zeigt die Kalibrierungsmessung auf dem Prüfstand an, ob die Funktion des Schwingungssensors 5 des Elektromotors 1 sowie der dazu gehörigen Messwerterfassungs- und Messwertverarbeitungskomponenten gegeben ist und plausible Messwerte generiert werden, da sie mit den Schwingungswerten der Prüfanlage verglichen werden.

Außerdem können noch Vibrationsmesswerte eines Rotors (ohne dazugehörigen Stator) beim Auswuchten des Rotors in einem "Dummy"-Stator durch einen Prüfsensor einer Wuchtanlage erfasst und beim Kalibrieren auf der Prüfanlage als zusätzliche Wertepaare bzw. als Kennlinie an die Datenbank bzw. den internen Speicher der Motorelektronik übergeben werden. Diese Informationen können verwendet werden, um den Schwingungseinfluss von Anbauteilen in einer Kundenapplikation herauszufiltern und zu bewerten.

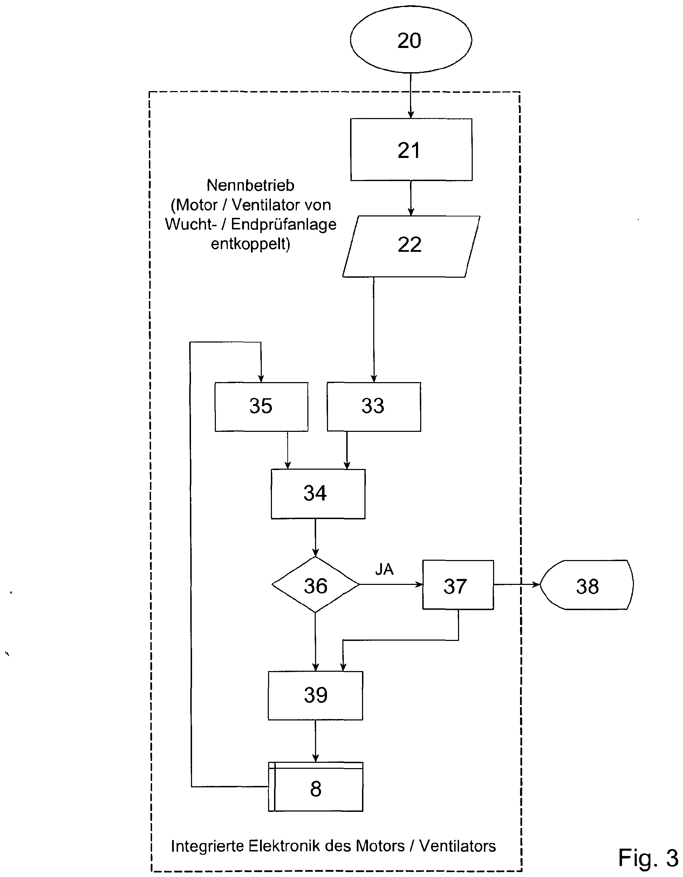

In Figur 3 ist der Elektromotor bzw. dessen Motorelektronik von der Prüfanlage entkoppelt. Damit sind diese Schritte im "normalen" Betrieb des Elektromotors, beispielsweise in einer Kundenanlage ausführbar. Die Schritte können dabei periodisch getriggert werden. Auch hier wird in einem initialen Schritt 20 der Elektromotor mit einer Drehzahl n betrieben. Dabei erzeugt der Elektromotor 1 Schwingungen, die durch einen Schwingungswert S - eine vorzugsweise mehrdimensionale Größe - repräsentiert sind. In dem darauffolgenden Schritt 21 werden Schwingungswerte des Motors mit dem Schwingungssensor 5 des Elektromotors 1 erfasst. In Schritt 22 wird mit dem Schwingungswert S und der zugehörenden Drehzahl ein Wertepaar W_{Motor} erzeugt und an Schritt 33 übergeben, in dem das Wertepaar W_{Motor} einem Komparator zur Verfügung gestellt wird. In Schritt 34 wird dieses Wertepaar W_{Motor} mit einem Referenzwert verglichen, der in Schritt 35 aus dem Speicher 8 geladen wird. Dabei ist der Komparator in dem Prozessor 6 implementiert.

Das Ergebnis des Vergleichs des Wertepaars W_{Motor} mit dem Referenzwert wird in Schritt 36 mittels einer Bewertungseinheit analysiert und ein Bewertungsmaß erzeugt. Das Bewertungsmaß ist hier als binäre Größe ausgebildet, die angibt, ob ein maximal zulässiger Schwingungswert überschritten ist oder nicht. Ist der Grenzwert für einen maximal zulässigen Schwingungswert überschritten, werden in Schritt 37 Maßnahmen zum Schutz des Elektromotors und/oder der Umgebung ergriffen, die beispielsweise in der Ausgabe einer Warnmeldung oder einer Drehzahlreduktion bestehen können (Schritt 38). Gleichzeitig kann dieses Ereignis mit den zugehörigen Messwerten in Schritt 39 im Speicher 8 abgespeichert werden. Ist der maximal zulässige Schwingungswert nicht erreicht wird in Schritt 39 das Wertepaar W_{Motor}, das Vergleichsergebnis und/oder weitere Größen in Speicher 8 abgespeichert.

In einem normalen Motorbetrieb - auch als Nennbetrieb bezeichnet - gibt das Ergebnis des Komparators an, wie stark die Schwingungen seit der Kalibrierungsmessung zugenommen haben. Daher dürfte der Vergleich in Schritt 34 einen umso größeren Wert liefern, je stärker die Schwingungen relativ zu der Kalibrierungsmessung zugenommen haben. Insofern kann dieses Vergleichsergebnis mit einem Grenzwert für eine maximal zulässige Schwingung verglichen werden und daraus ein zu starkes Schwingungsverhalten des Elektromotors abgeleitet werden. Dabei ist es unerheblich, ob die Schwingungen von dem Elektromotor selbst, dem durch den Elektromotor angetriebenen Laufrad, einer nicht-idealen Ansteuerung des Elektromotors oder der Einbauumgebung des Elektromotors stammen.

Hinsichtlich weiterer vorteilhafter Ausgestaltungen der erfindungsgemäßen Lehre wird zur Vermeidung von Wiederholungen auf den allgemeinen Teil der Beschreibung sowie auf die Ansprüche verwiesen.

Schließlich sei ausdrücklich darauf hingewiesen, dass die voranstehend beschriebenen Ausführungsbeispiele lediglich zur Erörterung der beanspruchten Lehre dienen, diese jedoch nicht auf die Ausführungsbeispiele einschränken.

### Bezugszeichenliste

- 1: Elektromotor
- 2: Prüfanlage
- 3: Schwingungen
- 4: Drehzahl
- 5: Schwingungssensor
- 6: Prozessor
- 7: Schnittstelle
- 8: Speicher
- 9: Prüfsensor
- 10: Drehzahlsensor
- 11: Datenerfassungseinheit
- 12: Prozessor
- 13: Schnittstelle
- 14: Datenausgabeeinheit
- 15: Datenbank

## Patentansprüche

1. Verfahren zum Bewerten eines Schwingungsverhaltens eines Elektromotors, umfassend die Schritte:
Bestimmen eines Schwingungswerts des Elektromotors (1) durch Messen einer Beschleunigung und/oder einer Geschwindigkeit von Schwingungen des Elektromotors (1) unter Verwendung eines Schwingungssensors (5) des Elektromotors (1), wobei Schwingungen in mindestens einer Richtung gemessen werden und wobei der Schwingungswert jede der gemessenen mindestens einen Richtung repräsentiert, wobei der Schwingungssensor in den Elektromotor und/oder in eine Motorelektronik des Elektromotors integriert ist,
Bestimmen einer aktuellen Drehzahl (n) des Elektromotors,
Vergleichen des Schwingungswertes mit einem Referenzwert des Schwingungswerts für die aktuelle Drehzahl und
Bestimmen eines Bewertungsmaßes zur Bewertung des Schwingungsverhaltens des Elektromotors basierend auf dem Vergleich des Schwingungswertes mit dem Referenzwert,
**dadurch gekennzeichnet, dass** eine Bewertung des Schwingungsverhaltens während eines Stillstands des Elektromotors, d.h. bei einer Drehzahl gleich 0, durchgeführt wird, wobei das dabei bestimmte Bewertungsmaß die Schwingungen einer Einbauumgebung des Elektromotors betrifft.

2. Verfahren nach Anspruch 1, **dadurch gekennzeichnet, dass** das Bewertungsmaß angibt, wie weit der Schwingungswert von einem maximal zulässigen Schwingungswert entfernt ist, und/oder
dass bei Erreichen oder Überschreiten eines maximal zulässigen Schwingungswertes eine Warnmeldung erzeugt wird und/oder Maßnahmen zum Schutz des Elektromotors (1) eingeleitet werden.

3. Verfahren nach Anspruch 1 oder 2, **dadurch gekennzeichnet, dass** für das Bestimmen des Schwingungswerts ein Schwingungssensor (5) verwendet wird, der in einer Motorelektronik des Elektromotors (1) angeordnet ist, oder
dass für das Bestimmen des Schwingungswerts ein Schwingungssensor (5) verwendet wird, der Bestandteil einer in einem Lagerrohr des Elektromotors (1) angeordneten Sensoranordnung ist.

4. Verfahren nach einem der Ansprüche 1 bis 3, **dadurch gekennzeichnet, dass** bei dem Bestimmen des Schwingungswerts Schwingungen des Elektromotors (1) in drei Richtungen gemessen werden, wobei die drei Richtungen vorzugsweise jeweils senkrecht zueinander sind.

5. Verfahren nach einem der Ansprüche 1 bis 4, **dadurch gekennzeichnet, dass** das Bestimmen des Schwingungswerts und die Bewertung des Schwingungsverhaltens wiederholt, vorzugsweise periodisch durchgeführt werden.

6. Verfahren nach einem der Ansprüche 1 bis 5, **dadurch gekennzeichnet, dass** der Schwingungswert und/oder das Bewertungsmaß in einem Speicher (8) abgespeichert und/oder über eine Kommunikationsschnittstelle (7) übertragen wird.

7. Verfahren nach einem der Ansprüche 1 bis 6, **dadurch gekennzeichnet, dass** der Referenzwert während einer Kalibrierungs- und/oder Hochlaufmessung bei mehreren unterschiedlichen Drehzahlen des Elektromotors (1) bestimmt wird, wobei Schwingungen des Elektromotors (1) mit dem Schwingungssensor (5) des Elektromotors (1) und mit mindestens einem Prüfsensor (9) gemessen werden und wobei der mindestens eine Prüfsensor (9) vorzugsweise Bestandteil einer Prüfanlage (2) ist.

8. Verfahren nach Anspruch 7, **dadurch gekennzeichnet, dass** zusätzlich zu dem Bestimmen des Referenzwertes ein Abweichungswert bestimmt wird, der einen Zusammenhang zwischen Messwerten des Schwingungssensors (5) des Elektromotors (1) und Messwerten des mindestens einen Prüfsensors (9) angibt, wobei der Abweichungswert vorzugsweise zu einem Anpassen des maximal zulässigen Schwingungswertes genutzt wird.

9. Verfahren nach Anspruch 7 oder 8, **dadurch gekennzeichnet, dass** eine Referenzwertkennlinie mit mehreren Referenzwerten bei unterschiedlichen Drehzahlen des Elektromotors in einer Motordatenbank (15) abgespeichert wird, wobei die Motordatenbank (15) Betriebsparameter mehrerer Elektromotoren enthält.

10. Verfahren nach einem der Ansprüche 1 bis 9, **dadurch gekennzeichnet, dass** die Bewertungsmaße bei zwei aufeinanderfolgenden Aktivierungen des Elektromotors miteinander verglichen werden und dass vorzugsweise bei Überschreiten eines vorgegebenen Schwellwerts auf das Vorliegen einer möglichen Beschädigung geschlossen wird.

## Claims

1. A method for evaluating a vibration behavior of an electric motor, comprising the steps of:
determining a vibration value of the electric motor (1) by measuring an acceleration and/or speed of vibrations of the electric motor (1) by using a vibration sensor (5) of the electric motor (1), wherein vibrations in at least one direction are measured and wherein the vibration value represents each of the measured at least one direction,
wherein the vibration sensor (5) is integrated in the electric motor (1) and/or in the motor electronics of the electric motor (1),
determining a current rotational speed (n) of the electric motor (1),
comparing the vibration value with a reference value for the current rotational speed, and
determining an evaluation measure for evaluating the vibration behavior of the electric motor (1) based on the comparison of the vibration value with the reference value, **characterized in that**
an evaluation of the vibration behavior is carried out when the electric motor is at a standstill, i.e., at a rotational speed equal to 0, wherein the evaluation measure determined thereby relating to the vibrations of an installation environment of the electric motor (1).

2. The method according to claim 1, **characterized in that** the evaluation measure indicates how far the vibration value is away from a maximum permissible vibration value, and/or that upon reaching or exceeding a maximum permissible vibration value, a warning message is generated and/or measures for protection of the electric motor (1) are introduced.

3. The method according to claim 1 or 2, **characterized in that** a vibration sensor (5) is arranged in the motor electronics of the electric motor (1) to determine the vibration value, or that
a vibration sensor (5) which is part of a sensor arrangement arranged in a bearing tube of the electric motor (1) is used to determine the vibration value.

4. The method according to any one of claims 1 to 3, **characterized in that** in the determination of the vibration value vibrations of the electric motor (1) are measured in three directions, the three directions preferably being perpendicular to one another.

5. The method according to any one of claims 1 to 4, **characterized in that** the determination of the vibration value and the evaluation of the vibration behavior are carried out repeatedly, preferably periodically.

6. The method according to any one of claims 1 to 5, **characterized in that** the vibration value and/or the evaluation measure are stored in a memory (8) and/or transmitted via a communication interface (7).

7. The method according to any one of claims 1 to 6, **characterized in that** the reference value is determined during a calibration and/or run-up measurement at several different rotational speeds of the electric motor (1), wherein vibrations of the electric motor (1) are measured with the vibration sensor (5) of the electric motor (1) and with at least one test sensor (9) and wherein the at least one test sensor (9) is preferably a component of a test system (2).

8. The method according to claim 7, **characterized in that**, in addition to determining the reference value, a deviation value is determined which indicates a relationship between measured values of the vibration sensor (5) of the electric motor (1) and measured values of the at least one test sensor (9), wherein the deviation value is used preferably for an adjustment of the maximum permissible vibration value.

9. The method according to claim 7 or 8, **characterized in that** a reference value characteristic curve with several reference values at different rotational speeds of the electric motor is stored in a motor database (15), wherein the motor data base (15) contains operation parameters of several electric motors.

10. The method according to any one of claims 1 to 9, **characterized in that** the evaluation measures are compared with each other at two successive activations of the electric motor and **in that**, preferably, exceeding a predetermined threshold is indicative of the presence of a possible damage.

## Revendications

1. Procédé d'évaluation d'un comportement vibratoire d'un moteur électrique, comprenant les étapes suivantes :
détermination d'une valeur de vibration du moteur électrique (1) par la mesure d'une accélération et/ou d'une vitesse des vibrations du moteur électrique (1) à l'aide d'un capteur de vibrations (5) du moteur électrique (1), dans lequel les vibrations sont mesurées dans au moins une direction et dans lequel la valeur de vibration représente chacune des au moins une direction mesurée, dans lequel le capteur de vibrations est intégré dans le moteur électrique et/ou dans une électronique du moteur électrique,
détermination d'une vitesse de rotation actuelle (n) du moteur électrique,
comparaison de la valeur de vibration avec une valeur de référence de la valeur de vibration pour la vitesse de rotation actuelle et
détermination d'une mesure d'évaluation pour l'évaluation du comportement vibratoire du moteur électrique sur la base de la comparaison de la valeur de vibration avec la valeur de référence,
**caractérisé en ce qu'**une évaluation du comportement vibratoire est effectuée pendant un arrêt du moteur électrique, c'est-à-dire lors d'une vitesse de rotation égale à 0, dans lequel la mesure d'évaluation déterminée concerne les vibrations d'un environnement d'installation du moteur électrique.

2. Procédé selon la revendication 1, **caractérisé en ce que** la mesure d'évaluation indique de combien la valeur de vibration est éloignée d'une valeur de vibration maximale admissible et/ou
lorsqu'une valeur de vibration maximale admissible est atteinte ou dépassée, un message d'alarme est généré et/ou des mesures pour la protection du moteur électrique (1) sont appliquées.

3. Procédé selon la revendication 1 ou 2, **caractérisé en ce que**, pour la détermination de la valeur de vibration, on utilise un capteur de vibrations (5) qui est disposé dans une électronique du moteur électrique (1) ou
pour la détermination de la valeur de vibration, on utilise un capteur de vibrations (5) qui fait partie d'une disposition de capteurs disposée dans un tube de montage du moteur électrique (1).

4. Procédé selon l'une des revendications 1 à 3, **caractérisé en ce que**, lors de la détermination de la valeur de vibration, les vibrations du moteur électrique (1) sont mesurées dans trois directions, dans lequel les trois directions sont parallèles entre elles.

5. Procédé selon l'une des revendications 1 à 4, **caractérisé en ce que** la détermination de la valeur de vibration et l'évaluation du comportement vibratoire sont effectuées de manière répétée, de préférence périodiquement.

6. Procédé selon l'une des revendications 1 à 5, **caractérisé en ce que** la valeur de vibration et/ou la mesure d'évaluation est enregistrée dans une mémoire (8) et/ou transmise par l'intermédiaire d'une interface de communication (7).

7. Procédé selon l'une des revendications 1 à 6, **caractérisé en ce que** la valeur de référence est déterminée pendant une mesure de calibrage et/ou de démarrage à plusieurs vitesses de rotation différentes du moteur électrique (1), dans lequel les vibrations du moteur électrique (1) sont mesurées avec le capteur de vibrations (5) du moteur électrique (1) et avec au moins un capteur de test (9) et dans lequel l'au moins un capteur de test (9) fait de préférence partie d'une installation de test (2).

8. Procédé selon la revendication 7, **caractérisé en ce que**, en plus de la détermination de la valeur de référence, une valeur d'écart est déterminée, qui indique une relation entre les valeurs de mesure du capteur de vibrations (5) du moteur électrique (1) et les valeurs de mesure de l'au moins un capteur de test (9), dans lequel la valeur d'écart est utilisée de préférence pour une adaptation de la valeur de vibration maximale admissible.

9. Procédé selon la revendication 7 ou 8, **caractérisé en ce qu'**une courbe caractéristique de valeurs de référence, avec plusieurs valeurs de référence à différentes vitesses de rotation du moteur électrique, est enregistrée dans une base de données de moteurs (15), dans lequel la base de données de moteurs (15) contient des paramètres de fonctionnement de plusieurs moteurs électriques.

10. Procédé selon l'une des revendications 1 à 9, **caractérisé en ce que** les mesures d'évaluation lors de deux activations successives du moteur électrique sont comparées et **en ce que**, de préférence lors du dépassement d'une valeur seuil prédéterminée, on en déduit l'existence d'un endommagement possible.
